# EUROPEAN PATENT APPLICATION

(11) **EP 1 220 363 A2**
(43) Date of publication of application: **03.07.2002**
(21) Application number: 01310253.8
(22) Date of filing: 07.12.2001
(51) Int. Cl.: H01R 13/22

(54) **An electrical connector**

(30) Priority: 21.12.2000 GB 0031366
(71) Applicant: Nokia Corporation, 02150 Espoo (FI)
(72) Inventor: Boakes, John, Berkhamsted HP4 3DJ (GB); Vaitkevicius, Simon Paul, Spalding PE11 1VY (GB)
(74) Representative: Johnson, Ian Michael

(57) **Abstract**

An electrical connector is disclosed. The connector has a substrate supporting a contact for making electrical connection with a corresponding contact on a mating part. The contact of the electrical connector is a resiliently deformable hollow projection. The connector finds particular use as a smart card reader.

## Description

This invention relates to an electrical connector. It finds particular, although not exclusive use in connectors for removable data cards, such as SIM cards in portable telephones. Other removable data cards include electronic payment cards, and data storage cards such as SD or MMC cards.

Portable telephones operating according to the GSM communication standard, amongst other standards, require the user to insert a SIM (Subscriber Identity Module) card before a communication link can be established with a host network. The SIM card is a type of so-called smart card, and has an embedded integrated circuit which contains information specific to a particular user, and enables him to access a communication network. Without a SIM cards, a portable telephone can generally only be used for emergency calls to a pre-defined number.

The SIM card has on its surface a number of discrete contact regions. These regions are planar conductive areas which internally connect with the embedded integrated circuit. Each region is insulated from its neighbours, and is intended to be contacted by a suitable reader forming part of a host device, such as a portable telephone. Typically, contact between the reader of the host device and the card has been effected using sprung metal contacts which are resiliently biased to contact respective regions of the SIM card.

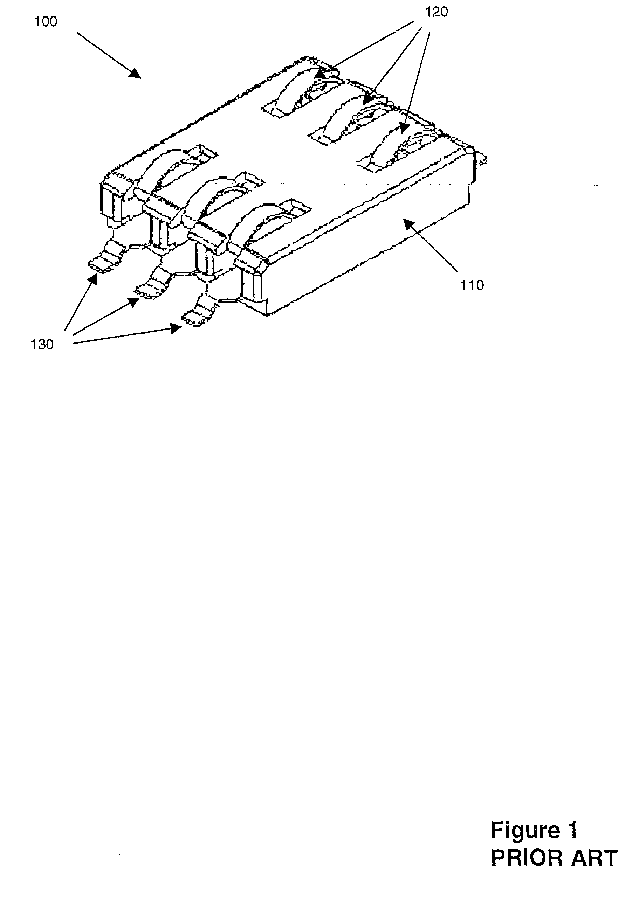

An example of a connector suitable for use as a SIM card reader is shown at Figure 1 of the accompanying drawings. The connector 100 comprises a body portion 110 composed of an insulating plastics material. The body portion houses a number of electrical connectors. On the upper surface of the body portion are six sprung electrical contacts 120 arranged to make contact with the conductive regions of a SIM card. These are either electrically connected to, or integrally formed with, respective contacts 130 for mounting the connector 100 on a circuit board. Each contact 130 is soldered to, and makes contact with, a trace on a printed circuit board (PCB).

In order to ensure a reliable connection between the SIM card and the contacts 120, a constant pressure needs to be applied to ensure that contact is maintained between the contacts of the SIM card, and the contacts 120 of the connector 100.

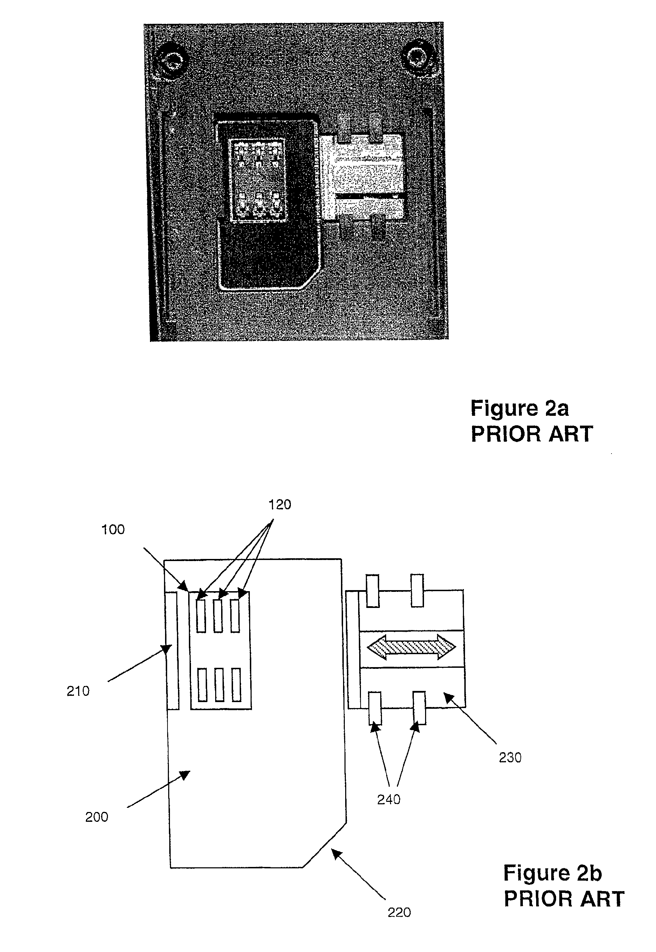

The required contact pressure may be applied in a number of ways. Some solutions require a carriage for holding the SIM card, which can be locked into position over the connector. However, a simple approach is illustrated in Figure 2a, and in more detail in Figure 2b.

Figure 2a shows a photographic representation of the SIM card reader from a Nokia ® 6210 portable telephone. Figure 2b shows a detailed schematic view of the reader.

The SIM card reader of Figure 2b comprises a cut away region 200 which receives a SIM card. The lower right hand corner of the cut away region has an orientation feature 220 which permits the SIM card to be inserted only one way.

A SIM card may be inserted by positioning its left hand edge under the projection 210. The projection 210 secures the card in position along its left hand edge. The right hand edge of the card is then lowered into the cut away region 200, covering the connector 100. To secure the SIM card in position, the sliding catch 230 is moved to the left so that the SIM card is held in position by a combination of the projection 210 and the catch 230.

The catch is simply a shaped metal part which is secured to run in a channel defined by projections 240.

Contact is then ensured, as the downward pressure provided by the card reader keeps the card in contact with the resilient contacts 120 of the connector 100.

In addition to SIM cards, portable devices are increasingly being provided with other removable memory devices. Examples of these include electronic payment cards for use with e-commerce or m-commerce (electronic or mobile commerce). In such systems, the user is able to pay for a purchase using an electronic payment card which may allow payment to be taken from his bank account or credit card account for instance.

Further, the increasingly multimedia nature of portable radiotelephones, e.g. the addition of digital camera capabilities, music playback facilities or video playback capabilities, means that large amounts of data must be generated or read locally. To this end, high capacity data storage cards are provided, which may be removably connected to the portable device. As an example, a portable telephone with a camera function may be able to take a photograph, and choose to either store the image locally on a data storage card, or send it via the communication network to another user. If the image is stored locally, the user can remove the card containing the image data, and transfer the data from the card to his PC for instance.

The height of the connector shown in Figure 1 is of the order of 2.7mm. The height of the SIM card itself is 0.8mm. These two dimensions, combined with the retaining means required, such as the sliding catch 230 of Figure 2b, can result in a total height of approximately 5 or 6mm for the SIM card reader. The increasing miniaturisation of portable telephone devices makes it increasingly difficult to accommodate the one or more removable memory devices required, and described above.

In particular, it is generally not practicable to reduce the size of existing connectors further as the contacts 120 become more prone to damage the smaller they become.

According to a first aspect of the present invention, there is provided an electrical connector for connection to a mating connector comprising a substrate supporting a contact for making electrical connection with a corresponding contact on the mating part, wherein the contact of the electrical connector is a resiliently deformable hollow projection

Advantageously, the connector may comprise several contacts so that a complete multi-pole connector may be provided.

Preferably, the contact of the connector is generally dome-shaped, i.e. it is hollow and has one generally convex exterior face, and a generally concave interior face.

The substrate on which the contacts may be mounted is preferably a flexible PCB, although a rigid PCB may also be employed.

The substrate preferably carries tracking for connecting the contacts to further circuitry in a host device.

The contacts may advantageously be attached to the substrate through use of a suitable solder or glue.

In order to ensure a reliable connection with the mating part, the connector preferably includes means for retaining the mating part in electrical contact with the reader.

Preferably, such means for retaining the mating part in reliable contact does not greatly increase the volume occupied by the connector. A suitable retaining device is a simple sliding catch operable to hold the mating part in location.

The contacts are preferably made from a metallic material as this has the desired conductive and resilient properties. However, it is possible that the contacts are composed of an insulating material, such as a plastics material, coated with a suitable conductive material.

Preferably, the contact is permanently connected to a conductive track on the substrate for further connecting the contact to associated circuitry.

In an advantageous embodiment, the connector can be configured to comprise a contact, or contacts, on each of two opposing surfaces of the substrate. In this way, the connector can be used for making contact with two mating parts simultaneously. This arrangement offers the benefit that the volume occupied by such an arrangement is only marginally greater than that occupied by the mating parts in isolation.

A beneficial use for the connector is as a smart card reader, where the smart card has its contacts disposed in a planar fashion on one or more of its surfaces.

A particular type of smart card benefiting from the invention is the so-called SIM card used in portable telephones.

For a better understanding of the present invention, and to understand how the same may be brought into effect, the invention will now be described, by way of example only, with reference to the appended drawings in which:
Figure 1 shows a prior art electrical connector used for making electrical connection to a smart card;
Figure 2a shows a pictorial representation of a prior art SIM card reader from a portable telephone;
Figure 2b shows a detailed schematic view of the reader of Figure 2a;
Figure 3a shows a plan view of a SIM card reader according to an embodiment of the invention;
Figure 3b shows a sectional view of the SIM card reader of Figure 3a;
Figure 4 shows the card reader of Figure 3 in-situ in a portable telephone;
Figure 5 shows an alternative card-reader configuration;
Figure 6a shows a configuration capable of reading two cards simultaneously;
Figure 6b shows an alternative configuration capable of reading two cards simultaneously;
Figure 7a shows a plan view of a twin card reader according to an embodiment of the invention; and
Figure 7b shows a cross sectional view of the card reader of Figure 7a.

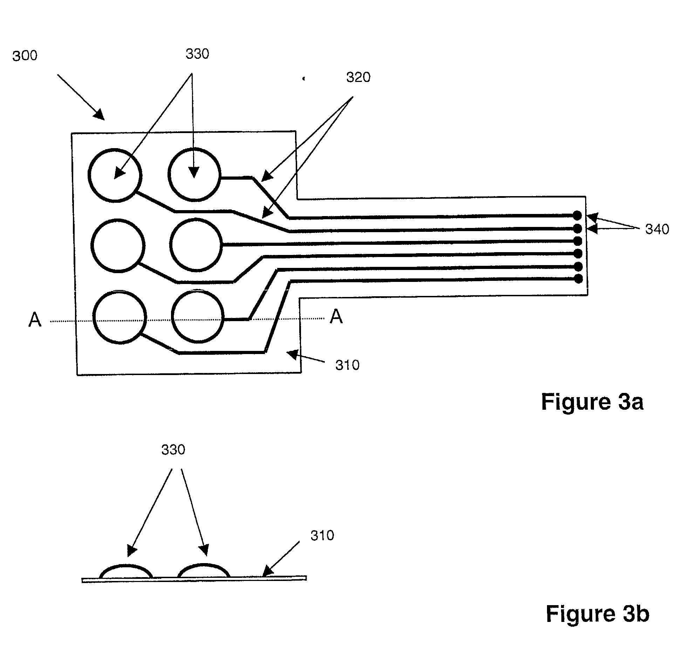

Figure 3a shows a SIM card reader 300 in accordance with embodiments of the present invention. The reader comprises a substrate material 310 onto which are printed conductive traces 320. Mounted onto the substrate in correspondence with portions of the conductive traces are several conductive hollow domes 330 acting as contacts. The domes are made of a conductive metal. An alternative composition for the domes is a plastics material coated with a conductive layer. The domes may be considered to be sections of a hollow sphere, somewhat smaller than a hemisphere in the present embodiment. The domes in this embodiments are generally circular at their base, and generally concave. However, the contacts need not be dome shaped in order to function according to embodiments of the invention.

The hollow nature of the dome 330 provides the resilience needed to ensure that a reliable electrical connection is maintained. As the dome is depressed by the application of a force, e.g. when a SIM card is connected, the dome structure is elastically deformed. However, as soon as the force is removed, the dome structure returns to its stable equilibrium position. Provided that the dimensions of the dome are chosen so as to minimise the effects of fatigue, many tens of thousands of such operations can be expected.

The contacts can be seen to be free-standing and self-supporting i.e. they require no supporting structure. This is in contrast to the prior art connector of Figure 1 which requires a relatively bulky insulating body portion 110 to provide structural integrity for the contacts. It would not be possible to simply remove the body portion of the prior art connector as the contacts would then be liable to short circuit, or be damaged in the absence of a supporting structure. Embodiments of the invention, by removing the need for such a body portion, greatly decrease the volume occupied by the connector.

The inherently stable shape of the dome contact offers advantages in that the individual domes may be easily placed on the flexible PCB 310 by automated machinery. However, other shapes of contacts would function adequately, and may be used according to embodiments of the invention. For instance, contacts having a non-circular outline, e.g. elliptical, could be used. Another alternative is the use of a hollow semi-cylindrical shaped contact with open ends, which would enjoy the same resilient property as the dome.

Figure 3b shows a sectional view of reader 300 along the line A-A. This clearly shows the domes 330 mounted on the substrate 310.

The substrate material is a flexible insulating material, such as is usually used in the manufacture of flexible PCBs. Printed onto the substrate in the usual way are a number of conductive traces. The traces run from one end of the substrate, where they provide contact pads 340 for connection to a connector for connecting the reader 300 to a PCB. At the opposite end to the contact pads 340, the traces terminate in a circular trace. The circular trace corresponds in size to the outline of the metal domes 330 which are attached to the substrate 310. The domes may be attached by a number of means such as by soldering or by use of a conductive glue.

The circular trace matching the circumference of the domes is only one possible trace configuration. The trace may consist of one or more discrete points lying on the circumference of the circle, or the circular trace may be filled.

Once assembled, the reader 300 may be fitted into the host apparatus, such as a portable telephone. This is achieved through use of a connector, fitted to the contact pads 340, mating with a corresponding connector in the host apparatus. Alternatively, the reader may be permanently connected to the host apparatus by forming it as part of a PCB of the host apparatus, for instance.

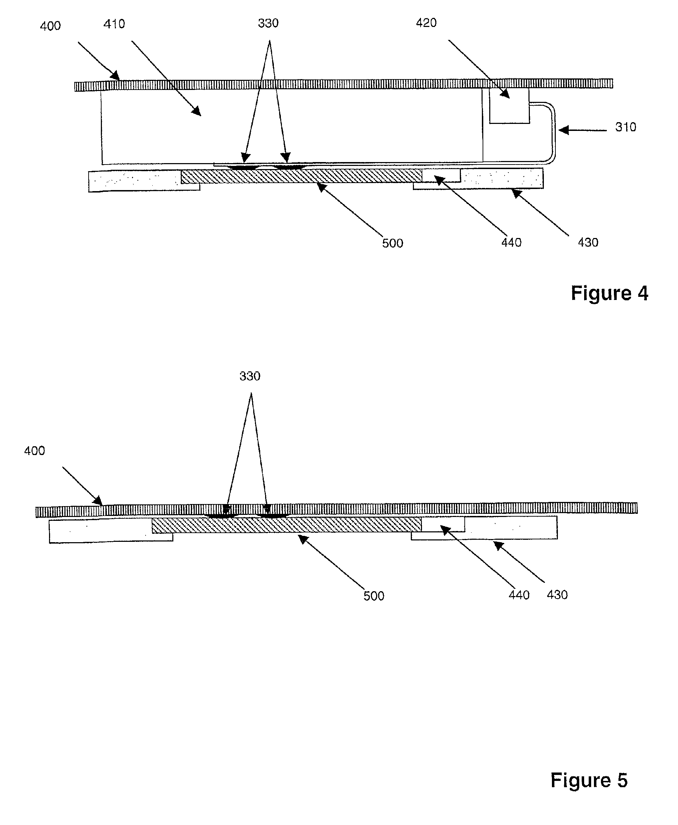

Figure 4 shows the reader 300 positioned in a host apparatus - in this case, a portable telephone. The main circuit board 400 of the telephone supports all the major components of the device. In particular, it accommodates the main processor, display driver, audio circuitry and RF circuitry. The RF circuitry is located inside a screened metal can 410. This prevents any stray RF signals interfering with other signals in the device.

Mounted on the surface of the can 410 is the SIM card reader 300. The domes 330 are oriented away from the can. The other end of the reader 300 terminates in a connector 420 which couples the reader to the circuit board 400, and thus to the processor of the telephone, enabling the SIM card to be accessed.

The SIM card 500 is located in a recess in a cover 430 of the telephone. It is held in place in the recess through use of a small sprung clip 440. Alternative means of holding it in place are possible. For instance, a sliding catch arrangement similar to that shown in Figures 2a and 2b could be used to secure the SIM card in position.

Once the SIM card is secured in the recess, it is brought into contact with the reader simply by attaching the cover 430 to the telephone. The cover may be attached in any convenient manner provided that a firm attachment is achieved. For instance, a known techniques of attaching a telephone cover is a sliding connection including latches to firmly grip the cover. Alternatively, the cover may be attached with screws or other retaining devices. This technique is more suitable for situations where regular changing of the SIM card, or similar smart card, is not required.

Once the card 500 is securely brought into contact with the reader 300, the domes 330 contact the respective regions of the SIM card, enabling an electrical connection between them to be established. Since the domes are hollow metal domes, they are resilient. This enables the domes to be almost completely flattened against the substrate if a sufficient force can be applied. The result of this is that the space taken up by the reader becomes almost negligible. The entire SIM card and reader arrangement in use is barely thicker than the thickness of the SIM card combined with the substrate 310 of the reader. For clarity, Figure 4 shows a larger gap between the SIM card and the substrate than could be achieved in practice.

Once the cover containing the SIM card is removed, the domes 330 spring back into their normal rest positions as shown in Figure 3b.

The reader 300 does not need to be mounted on the screened can 410 as shown in Figure 4. Instead, the reader may be completely integrated onto the main telephone printed circuit board 400. This configuration is shown at Figure 5. Like numerals refer to like features. Again, the gap between the SIM 500 and the substrate (in this case the circuit board 400) has been exaggerated for clarity.

In an enhancement of the present invention, a SIM card reader is presented which is capable of reading two SIM or other smart cards. There is a need for portable telephones to be able to access more than one set of information stored on different cards. For instance, in the application of m-commerce (mobile commerce), the user may wish to purchase an item direct from his telephone. To do this, he may need to insert a payment card into the telephone so that its stored details may be sent to the merchant's system at the other end of a communication link. It is envisaged that the payment card will be a smart card resembling closely the SIM card currently used in portable telephones.

In another configuration, it may be desirable to install two SIM cards, each one corresponding to a different network account with a different network provider. In this way, the user has access to more than one telephone account from a single telephone.

It is therefore desirable for the telephone to be able to accept and access more than one smart card at any given time.

Providing two prior art card readers may prove to use a prohibitive amount of scarce volume in a portable radio telephone. By providing two card readers as described below, it is possible the space occupied is comparable to that occupied by a single prior art card reader.

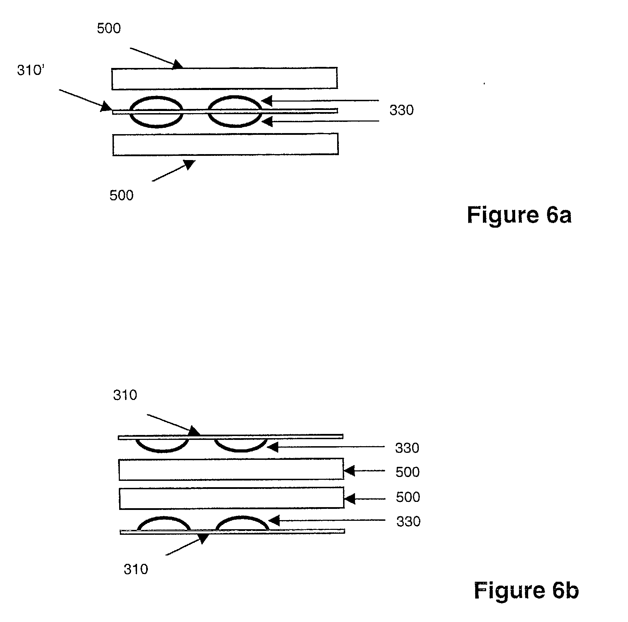

Figure 6a shows a substrate 310' having conductive domes 330 mounted on opposing surfaces. In this way, two SIM cards may be positioned as shown - one on each side of the reader. In this case, the substrate 310' may be made of a more rigid material than the flexible PCB used in the previous embodiment. Alternatively, the flexible PCB 310 of the previous embodiment may be fitted into a more rigid frame structure to provide the required rigidity.

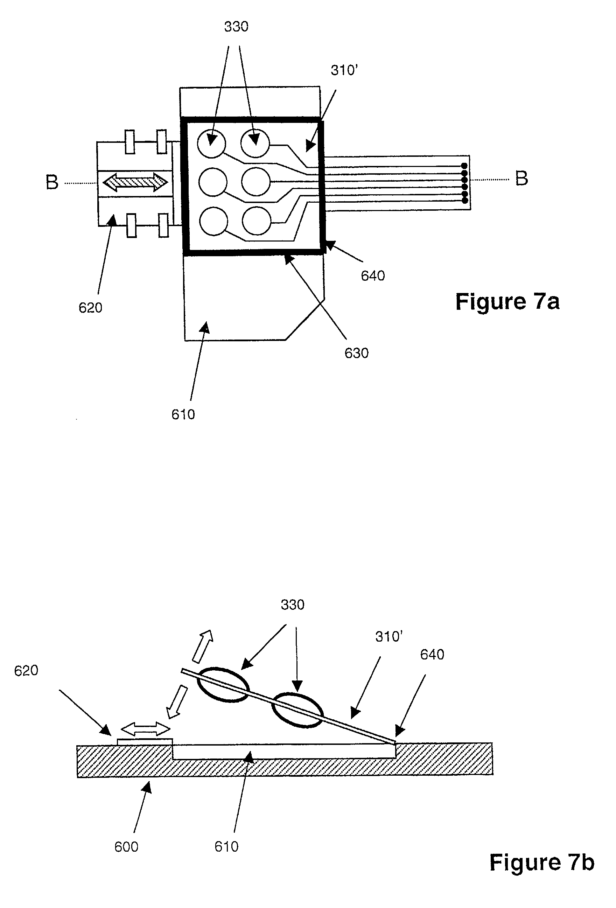

Figure 7a shows a plan view of the reader according to this embodiment of the invention. Figure 7b shows a cross-sectional view along line B-B. The reader is situated in the internal structure 600 of the portable telephone. A recess 610 is located in the structure for accommodating a first SIM card. Connected to the body 600 at hinge 640 is the reader of Figure 6a. This comprises the substrate 310', surrounded by a relatively rigid frame 630. The frame and substrate hinge as shown in Figure 7b so that the first SIM card may be inserted into the recess. Once inserted, the frame is lowered over the card, and catch 620 is slid across to maintain contact pressure between the reader and the card.

Once the first card is stowed in the recess, the second set of domes are left exposed on the top surface of the reader. It is with these domes that the second card (either a SIM card or another form of smart card) will make contact. The connection of the second card can be achieved as described in the first embodiment. i.e. a recess can be provided in another housing of the telephone, e.g. the rear housing, so that once attached, the card makes a reliable contact with the reader.

A benefit of such a structure, using a relatively rigid substrate 310' or frame 630, is that the reader is capable of operating with a single card in either one of the two available slots.

Use of the card reader of Figure 6b may be desirable in some situations, but it requires the use of a dummy card to maintain contact pressure if only a single card is in use.

Although described in terms of application to a reader of smart cards, particularly SIM cards, the skilled man would immediately realise that the connector herein described could be used in any situation requiring an electrical connector capable of making contact with a suitable mating part. Examples might include any type of removable or semi-permanent plug-in card.

The present invention includes any novel feature or combination of features disclosed herein either explicitly or any generalisation thereof irrespective of whether or not it relates to the claimed invention or mitigates any or all of the problems addressed.

## Claims

1. An electrical connector for connection to a mating connector comprising a substrate supporting a contact for making electrical connection with a corresponding contact on the mating part, wherein the contact of the electrical connector is a resiliently deformable hollow projection.

2. A connector as claimed in claim 1 wherein an exterior surface of the contact is generally convex.

3. A connector as claimed in claim 1 or 2 wherein the contact is generally dome-shaped.

4. A connector as claimed in any one of the preceding claims wherein the contact comprises a metal.

5. A connector as claimed in any one of claims 1 to 3 wherein the contact comprises an insulating material treated so as to be conductive.

6. A connector as claimed in any one of the preceding claims wherein the substrate comprises a Printed Circuit Board (PCB).

7. A connector as claimed in claim 6 wherein the PCB is flexible.

8. A connector as claimed in any one of the preceding claims wherein the substrate supports a conductive track electrically coupled to the contact.

9. A connector as claimed in any one of the preceding claims including means for retaining the mating part in contact with the connector.

10. A connector as claimed in any one of the preceding claims wherein the contact is secured in position on the substrate using solder.

11. A connector as claimed in any one of the preceding claims wherein the connector comprises a plurality of contacts.

12. A connector as claimed in any one of the preceding claims wherein the substrate supports a contact on each of two opposing surfaces of the substrate.

13. A connector as claimed in claim 12 wherein the connector is arranged to make contact with two mating parts arranged on opposing sides of the substrate.

14. A connector as claimed in claim any one of the preceding claims wherein the connector is for use as a smart card reader

15. A connector as claimed in claim 14 wherein the smart card is a SIM card for use with a portable telephone.

16. A portable telephone comprising a connector according to any one of the preceding claims.
